Europäisches Patentamt

European Patent Office

Office européen des brevets

(19)

(11) Publication number: **0 165 027**
A2

(12) # EUROPEAN PATENT APPLICATION

(21) Application number: 85304050.9

(22) Date of filing: 07.06.85

(51) Int. Cl.⁴: **H 01 L 29/78**
H 01 L 29/24, H 01 L 21/314
H 01 L 21/34, H 01 L 21/363
H 01 L 29/80

(30) Priority: 11.06.84 US 619053

(43) Date of publication of application:
18.12.85 Bulletin 85/51

(84) Designated Contracting States:
AT BE CH DE FR GB IT LI LU NL SE

(71) Applicant: STAUFFER CHEMICAL COMPANY

Westport Connecticut 06881(US)

(72) Inventor: Schachter, Rozalie
75-14 173rd Street
Flushing, NY 11366(US)

(72) Inventor: Viscogliosi, Marcello
176 North Washington Street
North Tarrytown, NY 10591(US)

(72) Inventor: Bunz, Lewis Andrew
24 Croton Park Road
Peekskill, NY 10566(US)

(74) Representative: Froud, Clive et al,
Elkington and Fife High Holborn House 52/54 High
Holborn
London WC1V 6SH(GB)

(54) Thin film field effect transistors utilizing a polypnictide semiconductor.

(57) A thin film transistor characterised in that it comprises, as a switched semiconductor portion thereof, a thin film comprising $MP_x$ wherein M represents at least one alkali metal; P represents at least one pnictide; and x ranges from 15 to infinity is disclosed.

A process for the production of a transistor characterised in that it comprises vacuum plasma sputtering of successive layers in contact of a semiconductor comprising $MP_x$, wherein M represents at least one alkali metal; P represents at least one pnictide; and x ranges from 15 to infinity; and an insulating layer comprising a pnictide is also disclosed.

An insulated semiconductor device characterised in that it comprises as the switched semiconductor portion thereof a layer comprising $MP_x$, wherein M represents at least one alkali metal; P represents at least one pnictide; and x ranges from 15 to infinity; and an insulating layer comprising a pnictide is further disclosed.

Referring to the accompanying illustrative diagram, a Schottky barrier thin film field effect transistor in accordance with the present invention may comprise a glass substrate (20), a high pnictide polypnictide semiconductor (22) of high resistivity, a metal (approximately 1% Ni) doped layer (24) of the same semiconductor material of lower resistivity and metal source (26), gate (28) and drain (30) contacts deposited on layer (24).

The present invention provides advances over the prior art.

FIG. I

"Thin film field effect transistors utilizing a polypnictide semiconductor"

This invention relates to thin film field effect transistors utilizing a polypnictide semiconductor; more particularly, it relates to semiconducting films of catenated phosphorus materials, to metal insulated field effect transistors (MISFETS), to metal semiconductor field effect transistors (MESFETS), to the modification and doping of polyphosphide semiconductors, to insulating layers utilized on polyphosphide semiconductors, to plasma sputtering and to the production of, for example, electronic semiconductor devices, thin films, electro-optical devices and displays.

For further information, reference may be made to, for example, GB-A- 2, 113, 663, EP-A- 130 803, EP-A- 132 323, EP-A- 132 954, EP-A- 132 326 and EP-A- 132 322, also to as yet unpublished European Applications 84 304 407.4, 84 304 411.6, 84 304 412.4, 84 304 413.2 and 84 304 414.0, as well as USSN 588, 948, USSN 588, 952, USSN 588, 946 and USSN 588, 949.

Electronic switched devices are needed for large area matrix applications, such as displays, particularly liquid crystal displays. These devices are utilized to switch on and off the individual elements (pixels) of the display and to address these individual pixel switches. Thin film transistors are desired for both of these applications.

Great difficulty has been experienced utilizing presently known semiconductors in such thin film devices. It is therefore highly desirable that other, or more easily fabricated and utilized semiconductors be provided for these applications.

The above-identified related disclosures concern, inter alia, a new class of semiconductors, in particular high pnictide polypnictide semiconductors corresponding to the following formula $MP_x$ wherein M represents an alkali metal; P represents one or more pnictides; and x ranges from 15 to infinity.

It has been disclosed in EP-A- 132 323, for example, that such polyphosphide semiconductors may be deposited as amorphous thin films to form electronic devices. More recently, it has been suggested that a Group V (pnictide)-containing dielectric ($P_3N_5$) be utilized to prevent loss of the volatile Group V element from III-V semiconductors and be used as the I layer deposited thereon. (Y. Hirota and T. Kobayaski, J. Appl. Phys. $\underline{53}$, 5037, (1982)).

One object of the present invention to provide thin film transistors.

An object of the present invention is to provide field effect transistors.

A further object of the present invention is to provide MISFETS and MESFETS.

Still another object of the present invention is to provide an insulating layer for transistors of the above character.

Yet another object of the present invention is to provide such transistors that may be utilized in large area matrix applications, particularly displays, such as liquid crystal displays.

A still further object of the present invention is to provide transistors of the above character utilizing a polypnictide semiconductor.

A yet further object of the present invention is to provide an insulating layer for transistors of the above character.

Another object of the present invention is to provide methods for fabricating transistors of the above character.

In one embodiment, the present invention relates to a thin film transistor characterised in that it comprises, as a switched semiconductor portion thereof, a thin film comprising $MP_x$ wherein M represents at least one alkali metal; P represents at least one pnictide; and x ranges from 15 to infinity.

Such a transistor may be, for example, a MESFET or a MISFET. In such a transistor, there may be present a thin film insulating layer in contact with the thin film comprising $MP_x$. The insulating layer may consist essentially of $SiO_2$, $Al_2O_3$ or $Si_3N_4$. This layer may comprise or consist essentially of a compound containing a pnictide, more particularly at least one compound comprising nitrogen and at least one other pnictide, for example $P_3N_5$ wherein P represents at least one other pnictide, preferably phosphorus. The semiconductor portion of a transistor in accordance with the present invention may comprise a minor amount of a metal to reduce the density of defect levels in the band gap. The presence of the metal may not substantially reduce the resistivity of the semiconductor portion. For example, the metal may comprise substantially less than $^1/2\%$ of the atoms of the semiconductor portion. Also, the semiconductor portion may comprise a minor amount of a metal to increase substantially the conductivity of at least a part of the semiconductor portion. For example, the metal may comprise substantially more than $^1/2\%$, more particularly substantially more than 1%, of the atoms of the part of the semiconductor portion. The metal may be selected from iron, chromium and nickel, which is preferred. The part of the semiconductor portion may lie adjacent to and in contact with a nickel layer of the transistor. Preferably, a titanium-containing metal layer will be in contact with the semiconductor layer. $MP_x$ is generally amorphous and is preferably $KP_{15}$.

The present invention also relates to a process for the production of a transistor characterised in that it comprises vacuum plasma sputtering of successive layers in contact of a semiconductor comprising $MP_x$, wherein M represents at least one alkali metal; P represents at least one pnictide; and x ranges from 15 to infinity; and an insulating layer comprising a pnictide.

The successive plasma sputtering steps may take place without breaking the vacuum. Also, the pnictide may be supplied in the deposition step and/or the sputtering step as $P_4$ species. Other preferred embodiments of such a process are apparent from the above.

Furthermore, the present invention relates to an insulated semiconductor device characterised in that it comprises as the switched semiconductor portion thereof a layer comprising $MP_x$, wherein M represents at least one alkali metal; P represents at least one pnictide; and x ranges from 15 to infinity; and an insulating layer comprising a pnictide.

The insulating layer of such a device may comprise nitrogen and, optionally, at least one other pnictide. For example, the insulating layer may contain $P_3N_5$. The preferred pnictide is phosphorus. In the above formula, x preferably represents 15 and/or M preferably represents potassium. As before, the semiconductor portion is preferably amorphous.

The local order of the semiconductor may vary from an all parallel pentagonal tube-like structure (preferred) to a layer like puckered sheet structure.

For a fuller understanding of the nature and objects of the present invention, reference may be made to the following detailed description, taken in connection with the accompanying drawings, wherein:

Figure 1 illustrates a diagrammatic cross-sectional view of a thin film Schottky barrier field effect transistor (MESFET) according to the present invention;

Figure 2 illustrates a diagrammatic cross-sectional view of a thin film insulated gate field effect transistor (IGFET), a type of metal insulated field effect transistor (MISFET) according to the present invention;

0165027

Figures 3, 4, 5 and 6 illustrate alternative forms of thin film MISFETS according to the present invention; and

Figure 7 illustrates an alternative form of thin film MISFET, similar to Figure 4, according to the present invention.

(The same reference characters refer to the same elements throughout the several views of the drawings).

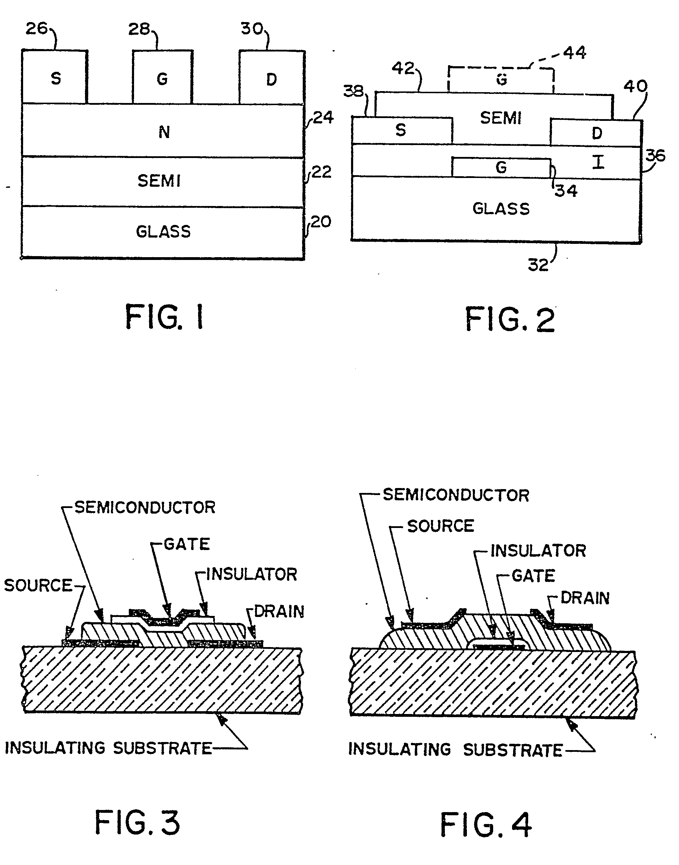

According to the present invention, thin film transistor structures may be formed on glass substrates utilizing amorphous $KP_{15}$ as the active semiconductor. For example, to form a MESFET, as illustrated in accompanying Figure 1, a high resistivity $KP_{15}$ layer may be deposited on a glass substrate by RF diode plasma sputtering. Then, an n layer of $KP_{15}$ doped with approximately 1% nickel may be formed in the same sputterer without breaking the vacuum. Metal contacts, which are preferably titanium, may then be deposited by electron beam evaporation.

According to the present invention, insulated gate field effect transistor (IGFET) structures, as illustrated in accompanying Figure 2, may be formed by first depositing a titanium gate on glass by electron beam evaporation, then depositing an insulating layer of, for example, $SiO_2$, $Al_2O_3$ or $Si_3N_4$ by conventional electron beam deposition, sputtering or, preferably, by plasma enhanced CVD. Preferably, however, there is deposited as insulating layer $P_3N_5$ by RF plasma sputtering utilizing a nitrogen atmosphere and providing $P_4$ molecules utilizing the method and apparatus disclosed in as yet unpublished European Application 84 304 414.0. The source and drain contacts may then be deposited on the insulating layer and a semiconductor layer of $KP_{15}$ deposited thereover. Alternatively, the gate may be deposited on top of the semiconductor layer, as illustrated in dotted lines in accompanying Figure 2, rather than being deposited on the glass substrate, as illustrated in solid lines.

The semiconductor $KP_{15}$ preferably has deposited therewith slightly less than $^1/2\%$ of nickel, iron or chromium, which reduces the density of defect levels in the bandgap without significantly increasing the conductivity of the semiconductor.

Alternatively, the semiconductor may be heavily doped, that is, with greater than $^1/2\%$, preferably about 1%, nickel, iron or chromium, which effectively increases the conductivity to form a device which is normally ON and may be turned off by the field effect rather than an undoped normally OFF device which is turned on by the field effect. Various forms of thin film transistors that may be formed according to the present invention are illustrated in accompanying Figures 3, 4, 5 and 6. Some of these have the advantage that adjacent semiconductor and insulating layers may be deposited successively in a plasma sputterer without breaking the vacuum.

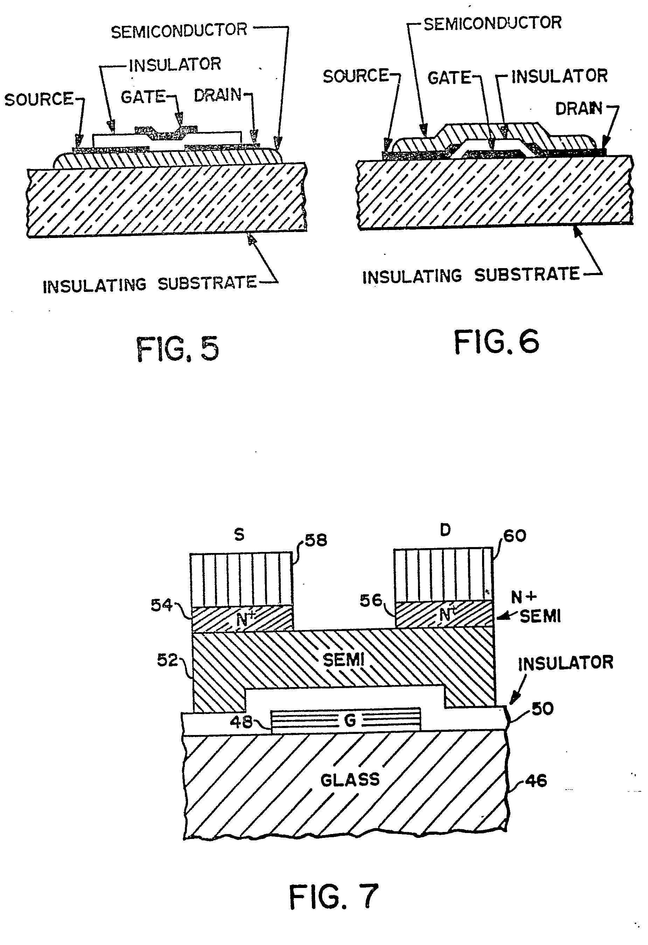

An n+ region of heavily doped (2-3% Ni) $KP_{15}$ may be deposited directly under the source and drain as illustrated in accompanying Figure 7. These layers are highly conductive and provide good contact between the main semiconductor body and the source and drain.

A field effect transistor is called a "unipolar" transistor to distinguish it from the bipolar (junction) transistors in which both types of carriers (p and n) are involved. The field effect transistor is a three terminal device in which lateral current flow is controlled by an externally applied vertical electric field.

A Schottky barrier thin film field effect transistor that is a thin film metal semiconductor field effect transistor (MESFET) structure according to the present invention is illustrated in accompanying Figure 1. It comprises a glass substrate 20, a high pnictide polypnictide semiconductor 22 of high reistivity, a metal (approximately 1% Ni) doped layer 24 of the same semiconductor material of lower resistivity and metal source 26, gate 28 and drain 30 contacts deposited on layer 24.

The n channel is modulated by a Schottky barrier at the interface of the gate and the n layer.

The insulated gate field effect transistor (IGFET) is the most general device of this nature and the most applicable to thin film transistors (TFT). In the most general form, the channel is modulated by a metal insulator semiconductor junction, that is, the device is a metal insulator semiconductor field effect transistor (MISFET). Such a device according to the present invention is illustrated in accompanying Figure 2. Here, a glass substrate 32 has deposited thereon a metal gate contact 34. An insulating layer 36 is deposited over the gate 34 and the glass 32. Then, metal source and drain 38 and 40, respectively, are deposited on the insulating layer 36. According to the present invention, a semiconducting polypnictide layer 42 is then deposited over the source and drain and the exposed I layer 36 over the gate 34. The I layer may be an oxide, an insulating dielectric or a combination thereof.

Alternatively, the gate 44 may be located on top of the semiconductor layer 42 as illustrated in dotted lines. Commonly fabricated thin film transistor structures such as illustrated in accompanying Figures 3, 4, 5 and 6, may be formed according to the present invention utilizing a polypnictide semiconductor. The semiconductor layer according to the present invention may be a high resistivity undoped polypnictide in which case the devices are normally OFF and switched ON by the field effect. Alternatively, the semiconductor may be heavily doped with approximately 1% metal to increase the conductivity thereof, in which case the devices would be operated normally ON and turned OFF by the field effect.

If the devices employ a high resistivity undoped semiconductor (metal content less than about $^1/2\%$), it is

desirable that heavily doped n+ layers be utilized under the source and drain for good contact to the undoped semiconductor. For example, as illustrated in accompanying Figure 7, the glass substrate 46 has first deposited thereon a metal gate 48, then the insulator layer 50, then the high resistance, undoped semiconducting polypnictide 52, then the doped n+ layers 54 and 56, which are just under the metal source and drain 58 and 60.

A device having such a structure would have a low current carrying capability and require a low voltage at the gate. Such a device would be most suitable for addressing liquid crystal matrix arrays.

Thin film transistors according to the present invention may be fabricated as follows:

Referring to accompanying Figure 2, a plurality of metal gate electrodes, such as electrode 34, are deposited on the glass substrate 32. Various suitable metals may be employed, however, titanium is preferred since it may be deposited by electron beam evaporation, shows no reaction with polypnictides and sticks well to glass. The length of the gate, that is, the distance between the source and drain 38 and 40, may vary from 10 to 100 microns (μm) The thickness of the gate is not critical, but may conveniently be from 2,000 to 6,000 angstroms $(10^{-10}m)$. For example, 7059 glass has ben utilized as the substrate in an electron beam evaporator at room temperature. The metal gate electrodes may be defined by lithographic techniques, such as lift-off.

The insulating layer may be conventional, that is, $SiO_2$ may be deposited by electron beam evaporation on the glass 32 and gates 34, heated to from 300 to 400°C or $Al_2O_3$ may be deposited in an electron beam evaporator also on a heated substrate. An $Si_3N_4$ insulating layer 3 may be deposited according to known techniques on a room temperature substrate by RF diode sputtering.

Alternatively, these materials, $SiO_2$, $Al_2O_3$ and $Si_3N_4$, may preferably be deposited by plasma enhanced chemical vapour deposition.

However, it is believed that $P_3N_5$ would provide the best I layer for such devices. While it may be deposited by a two-source thermal deposition technique, as utilized in the prior art to apply it to III-V semiconductors, it is preferred to deposit $P_3N_5$ by the method and in the RF diode sputtering apparatus disclosed in EP-A- 132 323, for example, utilizing the continuous pnictide delivery system disclosed in as yet unpublished European Application 84 304 414.0. A nitrogen atmosphere is used and $P_4$ species supplied by the pnictide delivery system (phosphorus bubbler), the substrate being heated to approximately 300°C.

In all cases, the insulating layer may be from 1,000 to 5,000 angstroms ($10^{-10}$m) in thickness and it may be defined by depositing through a photoresist or utilizing a lift-off technique.

After the I layer has been deposited, source 38 and drain 40 may be deposited by conventional electron beam evaporation to a thickness of from 2,000 to 4,000 angstroms ($10^{-10}$m). Various suitable metals may be employed, however, it has been found that titanium is best for pnictide-containing insulating and semiconducting layers, such as $P_3N_5$ and $KP_{15}$.

A polypnictide semiconducting layer 42 is then deposited in accordance with the two above-identified disclosures in an RF diode sputterer utilizing the continuous pnictide source for $P_4$ species. Preferred polypnictide semiconductors correspond to the following formula $MP_x$ wherein M represents an alkali metal; P represents a pnictide; and x ranges from 15 to infinity. The preferred pnictide is phosphorus, the preferred alkali metal is potassium and x is preferably 15. Furthermore,

$KP_{15}$, wherein P represents pnosphorus is the preferred material. However, minor amounts of other pnictides, such as arsenic, antimony and bismuth, may be incorporated into the dominant phosphorus pnictide semiconductor layer.

The semiconductor layer 42 is preferably from 5,000 to 10,000 angstroms ($10^{-10}$m.) in thickness.

Those skilled in the art will understand that structures wherein the semiconductor and insulator layers are deposited successively, such as semiconductor, then insulator (Figure 3), insulator, then semiconductor (Figure 4), have the advantage that the polypnictide semiconductor and a pnictide-containing insulator $P_3N_5$ or $Si_3N_4$ may successively be deposited in an RF plasma sputterer without breaking the vacuum.

It is preferred that a compatible metal be incorporated into the polypnictide semiconductor layer to reduce the density of defect levels in the bandgap, but not so much as to cause a significant increase in conductivity. It has been found that approximately $1/2\%$ or a little less of nickel, iron or chromium for example, performs this function and that nickel i preferred.

Such highly resistive layers provide for normally OFF devices.

Alternatively, normly ON devices may be provided by incorporating approximately 1% or more of the same metals which increase the conductivity of the semiconductor.

Other methods may be employed to deposit the high pnictide polypnictide semi inducting layers of such devices, such as chemical vapour decosition or molecular flow deposition, as disclosed i the above related applications. The semiconducting layers my range from 5,000 to 10,000 angstroms ($10^{-10}$m) in thiciness.

Now, referring to accompanying Figure 7, when the semiconductor 52 is of high resistivity, that is contains no more than approximately $1/2\%$ of metal additive, it is preferred to provide heavily doped, that is 2-3% metal, layers 54 and 56 under the source and drain to provide for good contact between the source and drain. These layers, which are typically from 500 to 3,000 angstroms ($10^{-10}$m) thick, are heavily doped with 2-3% iron, chromium or nickel, for example, preferably nickel. These layers may be deposited in the same sputtering apparatus as the semiconductor layer 52, without breaking the vacuum utilizing a composite target of $KP_{15}$ and nickel as disclosed in EP-A- 132 323."

The metal contacts 58 and 60 which again are preferably titanium, are deposited as a source and drain. It is preferred to use lithography to define the source and drain and to etch the polypnictide layer 52 back to the insulator 50 to isolate individual devices on a single glass substrate 46. Holes are etched through the insulating layer 50 to access the gates 48.

In the MESFET structure illustrated in accompanying Figure 1, the n layer is typically from 5,000 to 10,000 angstroms ($10^{-10}$m) in thickness. The high resistivity layer 22 of $KP_{15}$ is deposited on glass 20 in an RF sputtering apparatus as disclosed in above-identified EP-A- 132 323 from a $KP_{15}$ target and thereafter the n layer of $KP_{15}$ doped with approximately 1% nickel is deposited in the same apparatus without breaking the vacuum from a composite target as disclosed therein.

In this example, there was utilized an argon atmos-- phere, pressed $KP_{15}$ targets in the sputtering apparatus to deposit the $KP_{15}$ layers and added metal pieces to targets used to deposit doped $KP_{15}$ layers, all as disclosed in the above-mentioned reference. Excess $P_4$ was supplied using the phosphorus bubbler disclosed in the above-identified as yet unpublished European Application 84 304 414.0.

When the structure permits, successive undoped and

0165027

doped layers may be deposited by switching between appropriate targets and the I layers of $P_3N_5$ or $Si_3N_4$ may be deposited by switching to a nitrogen atmosphere and using the phosphorus bubbler for $P_3N_5$ or a silicon target for $Si_3N_4$, all without breaking the vacuum.

All of the thin film layers of the various structures and articles exemplified herein are preferably amorphous.

All Periodic Table references are to the table printed in the inside front cover of the 60th Edition of "The Handbook of Chemistry and Physics" published by the CRC Press Inc., Boca Raton, Florida, USA. Alkali metals are identified thereon and herein in Group 1A and pnictides in Group 5A.

Claims:

1. A thin film transistor characterised in that it comprises, as a switched semiconductor portion thereof, a thin film comprising $MP_x$ wherein M represents at least one alkali metal; P represents at least one pnictide; and x ranges from 15 to infinity.

2. A thin film transistor as claimed in claim 1 wherein the transistor is a MESFET or a MISFET.

3. A thin film transistor as claimed in claim 1 or claim 2 wherein there is present a thin film insulating layer in contact with the thin film comprising $MP_x$.

4. A thin film transistor as claimed in claim 3 wherein the insulating layer consists essentially of $SiO_2$, $Al_2O_3$ or $Si_3N_4$.

5. A thin film transistor as claimed in claim 3 wherein the insulating layer comprises or consists essentially of a compound containing a pnictide.

6. A thin film transistor as claimed in claim 5 wherein the insulating layer comprises or consists essentially of at least one compound comprising nitrogen and at least one other pnictide.

7. A thin film transistor as claimed in claim 6 wherein the insulating layer comprises or consists essentially of $P_3N_5$, wherein N represents nitrogen; and P represents at least one other pnictide.

8. A thin film transistor as claimed in claim 7 wherein P in $P_3N_5$ comprises or consists essentially of phosphorus.

9. A thin film transistor as claimed in any of claims 1 to 8 wherein the semiconductor portion comprises a minor amount of a metal to reduce the density of defect levels in the band gap.

10. A thin film transistor as claimed in claim 9 wherein the presence of the metal does not substantially reduce the resistivity of the semiconductor portion.

11. A thin film transistor as claimed in claim 10 wherein the metal comprises substantially less than $1/2\%$ of the atoms of the semiconductor portion.

12. A thin film transistor as claimed in any of claims 1 to 8 wherein the semiconductor portion comprises a minor amount of a metal to increase substantially the conductivity of at least a part of the semiconductor portion.

13. A thin film transistor as claimed in claim 12 wherein the metal comprises substantially more than $1/2\%$ of the atoms of the part of the semiconductor portion.

14. A thin film transistor as claimed in claim 13 wherein the metal comprises substantially more than 1% of the atoms of the part of the semiconductor portion.

15. A thin film transistor as claimed in any of claims 9 to 14 wherein the metal is selected from iron, chromium and nickel.

16. A thin film transistor as claimed in claim 15 wherein the metal is nickel.

17. A thin film transistor as claimed in any of claims 12 to 16 wherein the part lies adjacent to and in contact with a metal layer of the transistor.

18. A thin film transistor as claimed in any of claims 1 to 17 wherein there is a metal layer in contact with the semiconductor layer, comprising or consisting essentially of titanium.

19. A thin film transistor as claimed in ary of claims 1 to 18 wherein the semiconductor portion consists essentially of $KP_{15}$.

20. A thin film transistor as claimed in any of claims 1 to 19 wherein the film comprising $MP_x$ is amorphous.

21. A process for the production of a transistor characterised in that it comprises vacuum plasma sputtering of successive $MP_x$, wherein M represents at least one alkali metal; P represents at least one pnictide; and x ranges from 15 to infinity; and an insulating layer comprising a pnictide.

22. A process as claimed in claim 21 wherein the successive plasma sputtering steps take place without breaking the vacuum.

23. A process as claimed in claim 21 or claim 22 wherein the pnictide is supplied in the deposition steps and/or the sputtering steps as $P_4$ species.

24. An insulated semiconductor device characterised in that it comprises as the switched semiconductor portion thereof a layer comprising $MP_x$, wherein M represents at least one alkali metal; P represents at least one pnictide; and x ranges from 15 to infinity; and an insulating layer comprising a pnictide.

25. A semiconductor device as claimed in claim 24 wherein the insulating layer comprises nitrogen and, optionally at least one other pnictide.

26. A semiconductor device as claimed in claim 24 or claim 25 wherein the insulating layer comprises or consists essentially of $P_3N_5$.

27. A semiconductor device as claimed in any of claims 24 to 26 wherein the pnictide is phosphorus.

28. A semiconductor device as claimed in any of claims 24 to 27 wherein x represents 15.

29.    ·A semiconductor device as claimed in any of claims 24 to 28 wherein M represents potassium.

30.    A semiconductor device as claimed in any of claims 24 to 29 wherein the semiconductor portion is amorphous.

26    28    30

| S | G | D |

24

N

22

SEMI

20

GLASS

**FIG. I**

42    44

38

G

SEMI

S    D    40

G    I    36

34

GLASS

32

**FIG. 2**

┌SEMICONDUCTOR

┌GATE

┌INSULATOR

SOURCE┐    ┌DRAIN

INSULATING SUBSTRATE

**FIG. 3**

┌SEMICONDUCTOR

┌SOURCE

┌INSULATOR

┌GATE

┌DRAIN

INSULATING SUBSTRATE

**FIG. 4**

SEMICONDUCTOR

INSULATOR

SOURCE   GATE   DRAIN

INSULATING SUBSTRATE

## FIG. 5

SEMICONDUCTOR

SOURCE   GATE   INSULATOR

DRAIN

INSULATING SUBSTRATE

## FIG. 6

S   58   D   60

54   N⁺   56   N⁺   N+ SEMI

52   SEMI   INSULATOR

48   G   50

GLASS   46

## FIG. 7